# EUROPEAN PATENT APPLICATION

(11) **EP 4 148 784 A1**
(43) Date of publication of application: **15.03.2023**
(21) Application number: 22189707.7
(22) Date of filing: 10.08.2022
(51) Int. Cl.: H01L 23/538

(54) **MINIMIZING DIE SHIFT IN EMBEDDED HETEROGENEOUS ARCHITECTURES**

(30) Priority: 10.09.2021 US 202117472048
(71) Applicant: INTEL Corporation, Santa Clara, CA 95054 (US)
(72) Inventor: MCREE, Robin, Chandler, 85286 (US); KANAOKA, Yosuke, Chandler, 85249 (US); DUAN, Gang, Chandler, 85248 (US); LIU, Jinhe, Chandler, 85286 (US); GOSSELIN, Timothy A., Phoenix, 85012 (US)
(74) Representative: 2SPL Patentanwälte PartG mbB

(57) **Abstract**

Disclosed herein are embedded heterogeneous architectures having minimized die shift and methods for manufacturing the same. The architectures may include a substrate, a bridge, and a material attached to the substrate. The substrate may include a first subset of vias and a second subset of vias. The bridge may be located in between the first subset and the second subset of vias. The material may include a first portion located proximate the first subset of vias, and a second portion located proximate the second subset of vias. The first and second portions may define a partial boundary of a cavity formed within the substrate and the bridge may be located within the cavity.

## Description

### FIELD OF THE DISCLOSURE

The present subject matter relates to microelectronics packages. More specifically, the present disclosure relates to minimizing die shift in embedded heterogeneous architectures used in microelectronics package applications.

### BACKGROUND

As demands for high performance computing (HPC) continue to rise, heterogeneous integration has become an important performance enabler. The focus to enable heterogeneous integration scaling is to push interconnect density with increased bandwidth and improved power efficiency. Many different advanced packaging architectures have been deployed to increase planar and three-dimensional input/output (I/O) wire per area density for higher data bandwidth requirements, and to enable more effective die disaggregation for heterogeneous integration to shorten the time to market. More recently, industry has moved into advanced packaging technologies such as die embedding or Si interposer to enable significantly higher package I/O counts and density to meet the HPC segment market demands and product performance needs.

### BRIEF DESCRIPTION OF THE FIGURES

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.

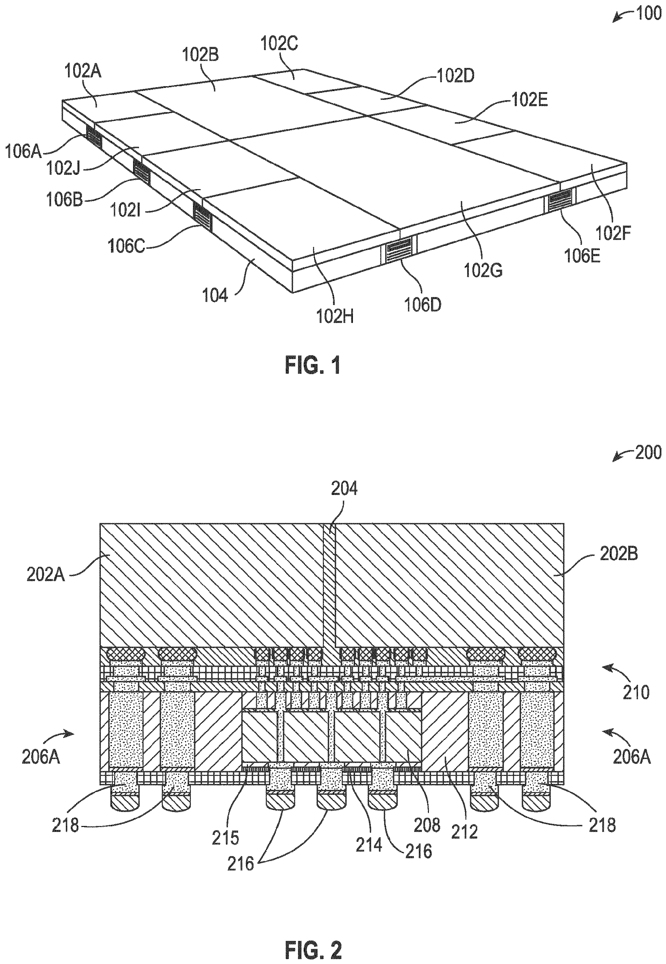

FIG. 1 shows a microelectronics package in accordance with at least one example of this disclosure.
FIG. 1 shows a microelectronics package in accordance with at least one example of this disclosure.
FIG. 2 shows a cross-section of a section of a microelectronics package in accordance with at least one example of this disclosure.
FIG. 3 shows a cross-section of a section of a microelectronics package in accordance with at least one example of this disclosure.
FIGS. 4A, 4B, and 4C show a process flow for forming a microelectronics packages in accordance with at least one example of this disclosure.
FIGS. 5A, 5B, and 5C show a process flow for forming a microelectronics packages in accordance with at least one example of this disclosure.
FIG. 6 shows system level diagram in accordance with at least one example of this disclosure.

### DETAILED DESCRIPTION

As disclosed herein, embedded multi-die interconnect bridge (EMIB) technology is an approach to in-package high density interconnects of heterogeneous chips that may provide high density I/O and controlled electrical interconnect paths between multiple dice in a package. As disclosed herein, local bridges, such a silicon bridges, organic bridges, glass bridges, etc., may be used to host ultrafine line and/or space structures for die-to-die interconnect communications and opens avenues for heterogeneous chip integration applications. In EMIB package architectures disclosed herein, a bridge, such as a silicon bridge die, may be embedded into an organic substrate, encapsulated with dielectric materials, and connected to external layers of package substrate through semi additive substrate build-up processes at the panel level. Many bridge dies may be embedded as part of the high-density interconnect package substrate fabrication process. Logic and/or heterogeneous dies (e.g., chiplets of various nodes/sources, high bandwidth memory (HBM), I/O tiles, etc.) may be bonded to EMIB substrates through assembly process, with EMIB bridges serving as a high-bandwidth, low-latency, and low-power solution for die-to-die communications, thereby enabling a low-cost, high-performance in-package heterogeneous chip integration solution. Simply put, EMIB may employ a silicon piece that hosts ultrafine line and/or space structures, fabricated with silicon far-backend technology, but out of high-density interconnect package substrate manufacturing infrastructures and capabilities.

The systems and method disclosed herein may allow EMIB technology to be used to connect vertically stacked 3D Si elements, sometimes referred to as Co-EMIBs. The Co-EMIB packaging technology, and methods of manufacturing the same, disclosed herein may allow for the interconnection of two or multiple elements for even more computing performance and capability. Analog, memory, and other tiles may be connected with high bandwidth and at low power. Combining EMIB and interposer technologies as disclosed herein, may help to overcome the manufacturing limitations in large-die, high-performance applications.

For heterogeneous architectures, embedding bridge dies accurately and reliably inside an organic substrate may allow for scaling EMIB and Co-EMIB advanced packaging technologies. Die movement during encapsulation may be a high-risk factor in fan-out wafer level processing (FOWLP) die embedding process. Die shift can lead to mis-alignment of downstream via formation, and ultimately electrical shorts.

The systematic die embedding interface designs and thermal process innovations disclosed herein may lead to restrictions in die movement and eliminate appreciable die shift during dielectric material encapsulation process. As disclosed herein, high pressure ovens may be utilized to cure die attach film (DAF) film before encapsulation process step. The result may be a feasible way to control die shift other than cavity architectures. Selection of appropriate DAF materials may help to minimize coefficient of thermal expansion (CTE) driven die dynamic warpage by tailoring DAF materials' mechanical and thermal properties for die embedding process. DAF material may be sustainable through upstream and downstream process steps such as wafer lamination, back grinding, dicing, and wafer die ejection. In addition, adhesive curing kinetics and thermal processes may be well characterized to minimize die shift and end-of-line local package coplanarity across EMIB bridge die area. As disclosed herein, DAF materials may absorb mechanical stresses induced from a CTE mismatch between the silicon die and the organic substrate thereby protecting the package from warpage and reliability failures.

During wafer level molding and/or encapsulation processes, liquid mold compound may flow toward a peripheral of a mold chase, which may result in an asymmetric pressure on one or more dies. This pressure may cause die shift and/or die rotation. The die shift magnitude has been characterized at tens of µm level for various wafer level processing (WLP) die embedding technologies (e.g., embedded wafer level ball grid array) when using different carriers and thermal release tapes.

The systems and methods disclosed herein provide for a compensation strategy at the die bonding step after systematically characterizing the die shift magnitude and direction for WLP technologies. As compared to eWLB based FOWLP architectures, the EMIB die embedding packaging technology disclosed herein may enable significant restrictions in die movement and eliminate appreciable die shift during dielectric material encapsulation process. The systems and methods disclosed herein may include interfaces between dies and underneath surfaces to minimize die shift magnitude.

The above discussion is intended to provide an overview of subject matter of the present patent application. It is not intended to provide an exclusive or exhaustive explanation. The description below is included to provide further information.

Turning now to the figures, FIG. 1 shows a microelectronics package 100 in accordance with at least one example of this disclosure. Microelectronics package 100 may include dies 102 (labeled individually as die 102A, 102B, ... 102J) connected to a substrate 104. Dies 102 may be any type of dies, such as, but not limited to, logic dies, high bandwidth memory dies, graphical processing unit dies, transmitter/receiver/transceiver dies, etc. Substrate 104 may define one or more voids for receiving one or more bridges 106 (labeled individually as bridge 106A, 106B, ... 106E). As disclosed herein, bridges 106 may be silicon bridges, glass bridges, organic bridges, interposers, EMIBs, etc. While FIG. 1 shows a two-dimensional integration, a three-dimensional integration is consistent with examples of this disclosure.

FIG. 2 shows a cross-section of a section of a microelectronics package 200 in accordance with at least one example of this disclosure. For example, FIG. 2 may represent a cross-section of microelectronics package 100 along any of bridges 106. Microelectronics package 200 may include a first die 202A and a second die 202B (collectively dies 202). Dies 202 may be set within a mold 204 having a first subset of pillars 206A and a second subset of pillars 206B (collectively pillars 206). A bridge 208 may be connected or otherwise electrically coupled to one or more bumps 210, which may connect pillars 206 and dies 202 by way of one or more traces or other circuitry embedded within microelectronics package 200. Bridge 208 may be embedded at least partially within a substrate 212.

As disclosed herein, during construction a material 214 may be attached to a carrier. Bridge 208 may be attached to the material 214 either before or during formation of substrate 212. One or more solder bumps 216 may be attached to vias 218 for later attachment of microelectronics package 200 to other structures, such as dies, control boards, etc. When forming vias 218, material 214 may be laser drilled, etched, etc. to form one or more through holes in material 214 to allow one or more of vias 218 to pass therethrough and connect or otherwise electrically couple bridge 208 with the one or more of vias 218. As disclosed herein, a DAF material 215 may also be deposited onto material 214 and used to attach bridge 208 to material 214.

As disclosed herein, material 214 may be a metallic material, a dielectric material, or a combination thereof. For example, material 214 may be a titanium plate, an Ajinomoto build-up film, a solder resist plate, or a combination thereof. During the fabrication process, material 214 may act as a stabilizing material and provide a solid surface to prevent movement of bridge 208. For instance, during the fabrication process, material 214 may provide a solid surface to prevent translation and/or rotation of bridges 208 during formation of substrate 212.

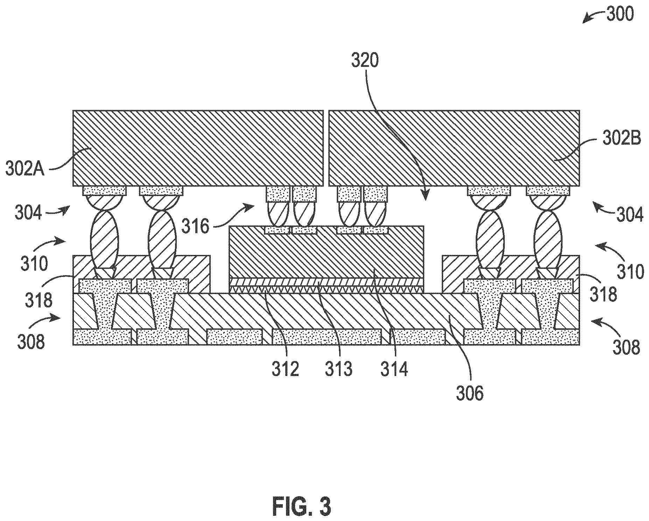

FIG. 3 shows a cross-section of a section of a microelectronics package 300 in accordance with at least one example of this disclosure. For example, FIG. 3 may represent a cross-section of microelectronics package 100 along any of bridges 106. Microelectronics package 300 may include a first die 302A and a second die 302B (collectively dies 302). Dies 302 may include bumps 304. Microelectronics package 300 may also include a substrate 306 that includes one or more vias 308. Bumps 310 may electrically couple dies 302 to vias 308.

A material 312 may be attached to substrate 306. As disclosed herein, material 312 may be a metallic material, a dielectric material, or a combination thereof. For example, material 312 may be a titanium plate, an Ajinomoto build-up film, a solder resist plate, or a combination thereof. During the fabrication process, material 312 may act as a stabilizing material and provide a solid surface to prevent movement of a bridge 314 attached to material 312. For instance, during the fabrication process, material 312 may provide a solid surface to prevent translation and/or rotation of bridged 314 during attachment of dies 302 via bumps 316. In addition, material 312 may prevent translation and/or rotation of bridge 314 when a mold 318 is formed around bumps 310 and/or during the formation of bumps 310. As disclosed herein, a DAF material 313 may also be deposited onto material 312 and used to attach bridge 314 to material 312.

As shown in FIG. 3, mold 318 and/or substrate 306 may not encapsulate portions of bridge 314. As a result, an open cavity 320 may be formed around bridge 314. Because bridge 314 is not at least partially encapsulated, pressure may be applied to bridge 314 as disclosed herein to secure bridge 314 to stabilizer material 312 during attachment of bridge 314 and/or during subsequent fabrication stages as disclosed herein.

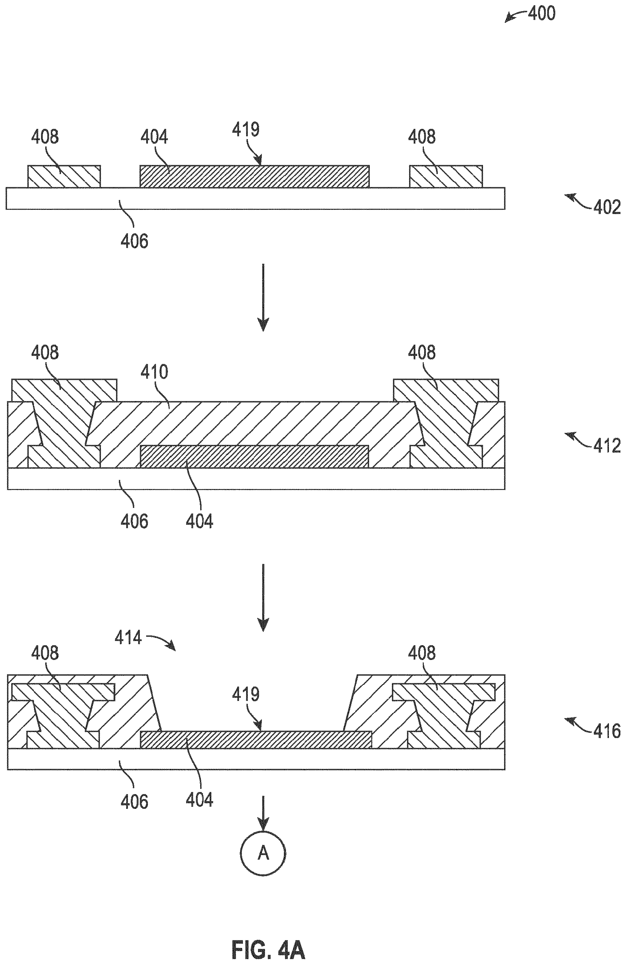

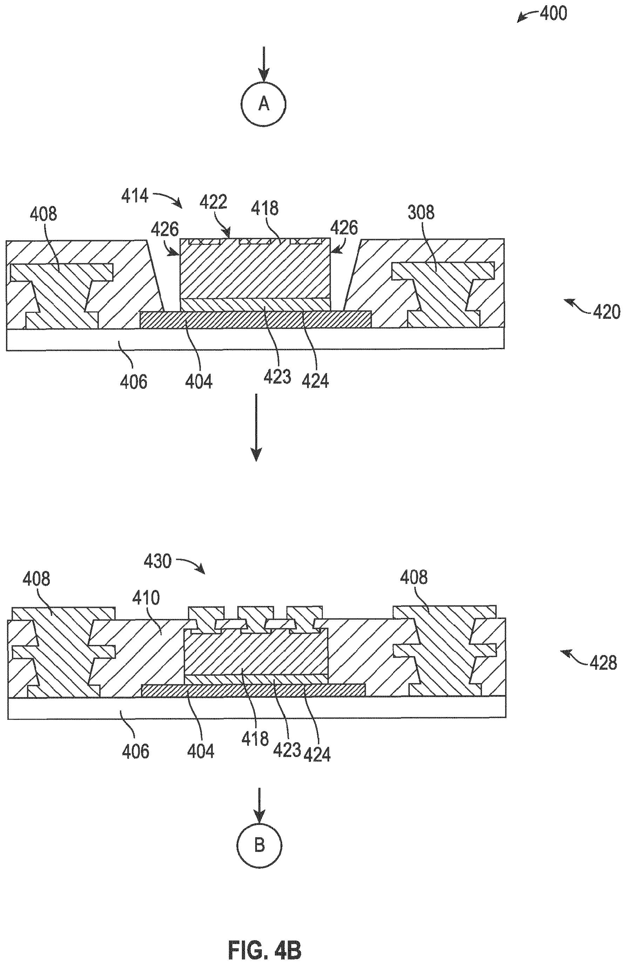

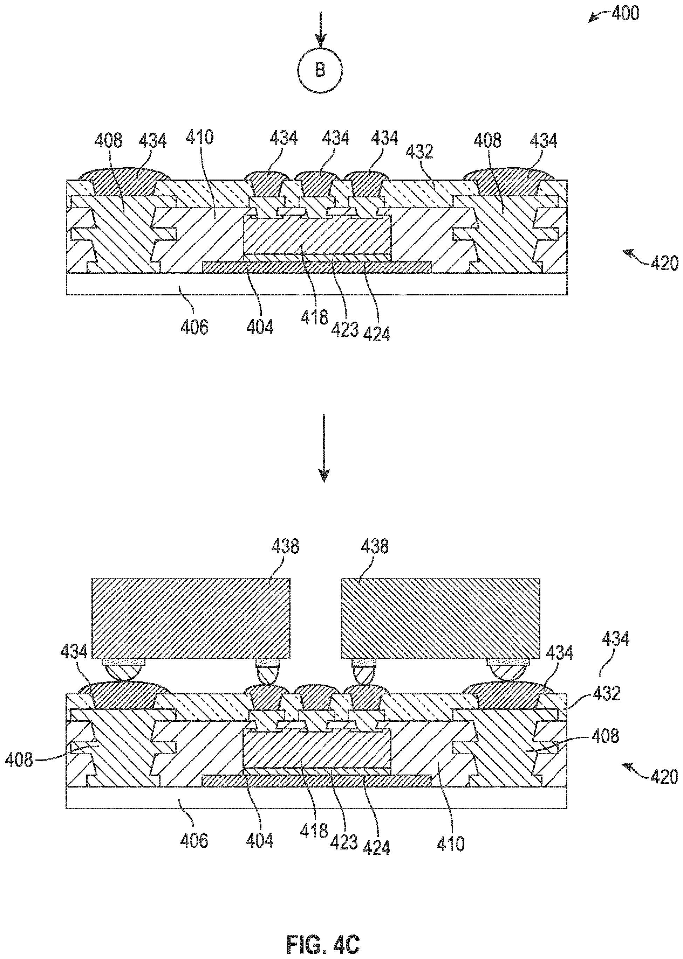

FIGS. 4A, 4B, and 4C show a process flow 400 for forming microelectronics packages, such as microelectronics package 100, in accordance with at least one example of this disclosure. Process flow 400 may begin at stage 402 where a material 404 may be attached to a carrier 406. Carrier 406 can be a glass carrier, a silicon carrier, etc. One or more vias 408 may also be formed.

Once material 404 and vias 408 are attached to carrier 406, a substrate 410 may be formed around material 404 and/or vias 408 (412). Vias 408 may also be extended as shown in stage 412. After forming substrate 410 may include forming a portion of substrate 412 or the entire substrate 412.

Once substrate 412 is formed, a cavity 414 may be formed in substrate 412 (416). Forming cavity 414 may include exposing a portion of material 404. Cavity 414 may be formed by laser drilling and/or etching substrate 412. As such, material 404 may act as a stopping material to limit the depth of cavity 414. For example, material 404 may be impervious to an etching material and/or reflect a laser used in laser drilling. Thus, material 404 may prevent a laser or etching material from removing too much of substrate 410.

Once cavity 414 is formed, a bridge 418 may be attached to a surface 419 of material 404 (420). Surface 419 of material 404 may have been exposed when cavity 414 was formed. Bridge 418 may be attached to material 404 using a heat treatment or other thermal bonding process. As disclosed herein, a DAF material 423 may also be deposited onto surface 419 and used to attach bridge 418 to material 404.

As disclosed herein, the process of attaching bridge 418 to material 404 may include a non-contact type process to freeze bridge 418 in position and minimize shifting. For example, the process of attaching bridge 418 to material 404 may include applying pressure to bridge 418 using a fluid instead of a mechanical press. The pressure may be applied by increasing an air pressure within a chamber used to form microelectronics packages. By increasing the air pressure, an evenly distributed force may be applied to bridge 418. Stated another way, by using a fluid, such as an inert gas (e.g., nitrogen, argon, etc.), an evenly distributed pressure may be applied to a surface 422 of bridge 418 regardless of any surface irregularities that may be present in surface 422. Thus, applying pressure with a fluid may create a uniform force being applied to bridge 418 across an interface 424 of bridge 418 and material 404.

Because material 404 and bridge 418 may be non-porous materials and when the pressure is increased, material 404 and bridge 418 may not allow the fluid to penetrate interface 424. Thus, the potential for the fluid to cause translation and/or rotation of bridge 418 is minimized. The potential for translation and/or rotation of bridge 418 is also minimized because the fluid will also apply uniform pressure to exterior surfaces 426 of bridge 418. Stated another way, applying pressure to bridge 418 may hold bridge 418 in a fixed position during attachment of bridge 418 to material 404 and subsequent stages of process flow 400.

Once bridge 418 is attached, a second portion of substrate 410 can be formed (428). The second portion of substrate 410 may be to backfill portions of substrate 410 removed during stage 416 to form cavity 414. Vias 408 may be further extended as needed and additional vias 430 may be formed after the second portion of substrate 410 is formed. Consistent with examples disclosed herein, cavity 414 need not be backfilled. For example, as shown in FIG. 3, an open cavity bridge architecture can be formed using process flow 400.

After the second portion of substrate 410 is formed, solder resist openings 432 and bumps 434 may be formed (436). In addition, one or more dies 438 may be attached to bumps 434 (440). For example, dies 438 may be attached to bumps 434 and bridge 418 may electrically couple dies 438.

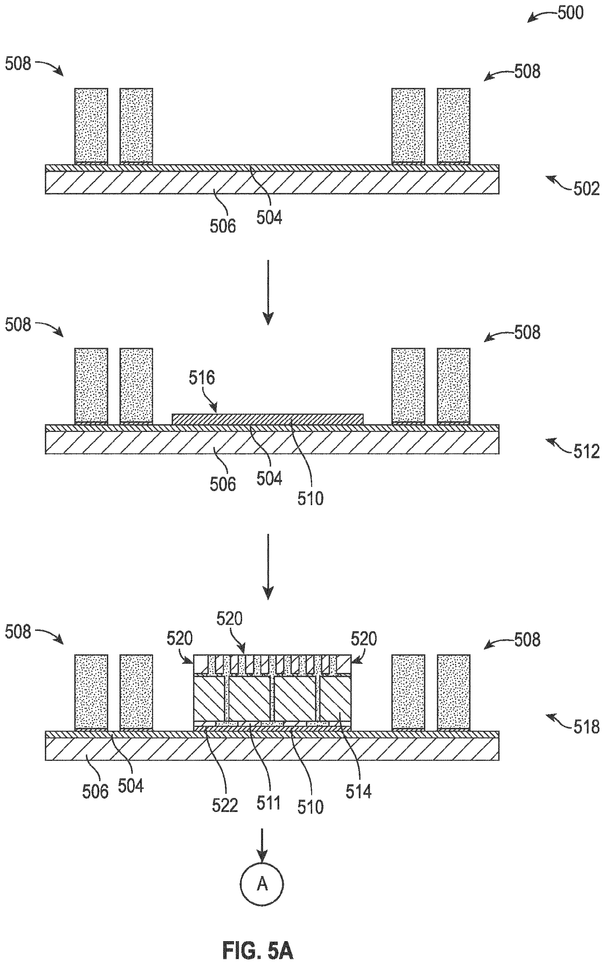

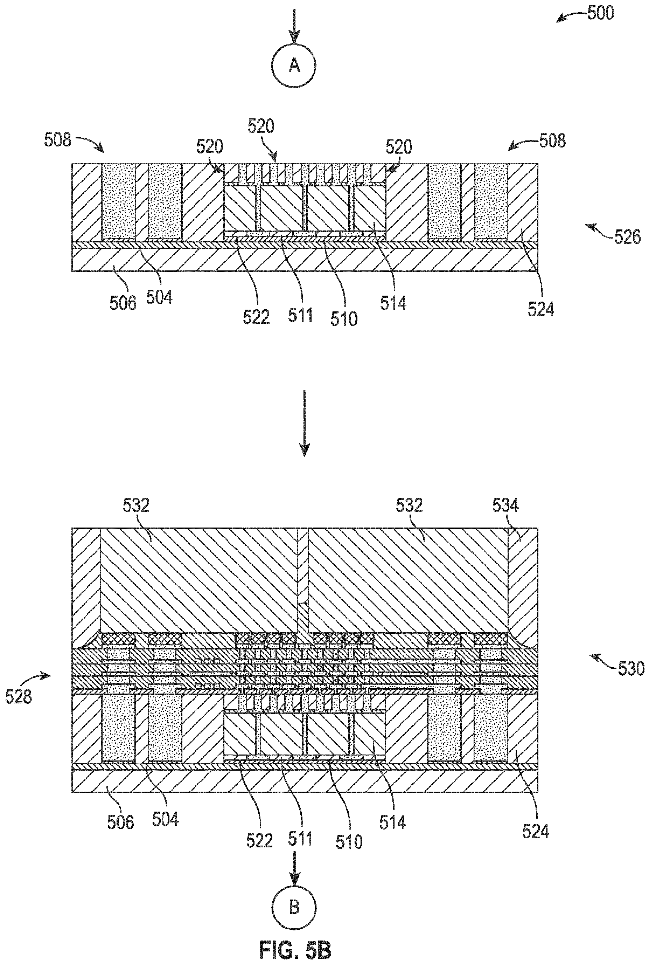

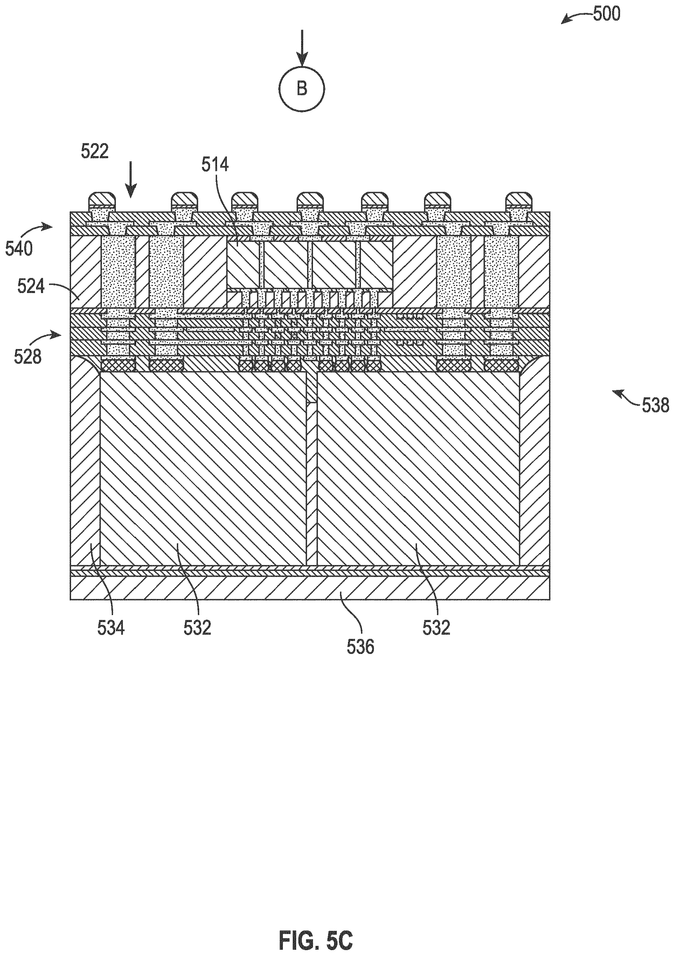

FIGS. 5A, 5B, and 5C show a process flow 500 for forming microelectronics packages, such as microelectronics package 100, in accordance with at least one example of this disclosure. Process flow 500 may begin at stage 502 where a release layer 504 may be deposited on a carrier 506 and pillars 508 formed. Once pillars 508 are formed a material 510 may be attached to carrier 506 (512). Carrier 506 can be a glass carrier, a silicon carrier, etc.

Once material 510 is attached to carrier 506 and pillars 508 are formed, a bridge 514 may be attached to a surface 516 (shown in stage 512 for clarity) of material 510 (518). Bridge 514 may be attached to material 510 using a heat treatment or other thermal bonding process. As disclosed herein, a DAF material 511 may also be deposited onto material 510 and used to attach bridge 514 to material 510.

As disclosed herein, the process of attaching bridge 514 to material 510 may include a non-contact type process to freeze bridge 514 in position and minimize shifting. For example, the process of attaching bridge 514 to material 510 may include applying pressure to bridge 514 using a fluid instead of a mechanical press. The pressure may be applied by increasing an air pressure within a chamber used to form microelectronics packages. By increasing the air pressure, an evenly distributed force may be applied to bridge 514. Stated another way, by using a fluid, such as an inert gas (e.g., nitrogen, argon, etc.), an evenly distributed pressure may be applied to surface 520 of bridge 514 regardless of any surface irregularities that may be present in surfaces 520. Thus, applying pressure with a fluid may create a uniform force being applied to bridge 514 across an interface 522 of bridge 514 and material 510.

As disclosed herein, material 510 and bridge 514 may be non-porous materials and when the pressure is increased, material 510 and bridge 514 may not allow the fluid to penetrate interface 522. Thus, the potential for the fluid to cause translation and/or rotation of bridge 514 is minimized. In other words, applying pressure to bridge 514 may hold bridge 514 in a fixed position during attachment of bridge 514 to material 510 and subsequent stages of process flow 500.

For example, once bridge 514 is attached to material 510, a substrate 524 may be formed around bridge 514 and pillars 508 (526). Forming substrate 524 may include backfilling spaces proximate pillars 508 and encapsulating bridge 514. Still consistent with examples disclosed herein, forming substrate 524 may not include encapsulating bridge 514, such as in open cavity bridge architectures sown in FIG. 3.

After substrate 524 is formed, redistribution layers 528, which may include vias, pillars, bumps, routing traces, etc. may be formed (530). After formation of redistribution layers 528, dies 532 may be attached to redistribution layers 528 and a mold 534 formed around dies 532. For example, dies 532 may be attached to redistribution layers 528 and bridge 514 may electrically couple dies 532.

After attaching dies 532 a second carrier 536 may be attached to dies 532 (538). Once second carrier 536 is attached to dies 532, carrier 506 may be removed. After removing carrier 506 additional redistribution layers 540 may be formed.

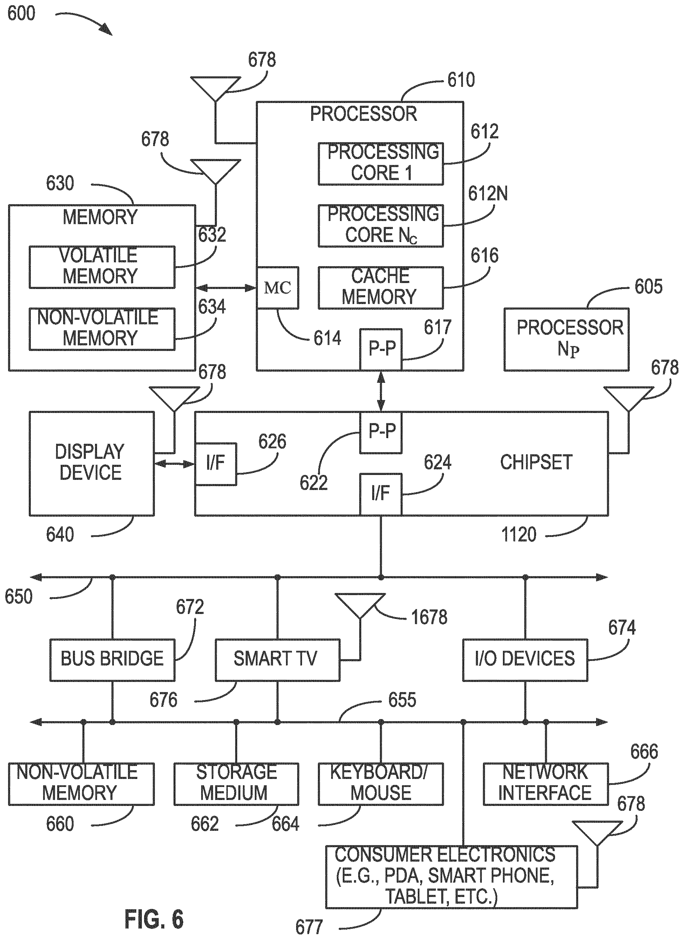

FIG. 6 illustrates a system level diagram, according to one embodiment of the invention. For instance, FIG. 6 depicts an example of an electronic device (e.g., system) including the microelectronics package 100 as described herein. FIG. 6 is included to show an example of a higher level device application for the present invention. In one embodiment, system 600 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 600 is a system on a chip (SOC) system.

In one embodiment, processor 610 has one or more processing cores 612 and 612N, where 612N represents the Nth processor core inside processor 610 where N is a positive integer. In one embodiment, system 600 includes multiple processors including 610 and 605, where processor 605 has logic similar or identical to the logic of processor 610. In some embodiments, processing core 612 includes, but is not limited to, pre-fetch logic to fetch instructions, decode logic to decode the instructions, execution logic to execute instructions and the like. In some embodiments, processor 610 has a cache memory 616 to cache instructions and/or data for system 600. Cache memory 616 may be organized into a hierarchal structure including one or more levels of cache memory.

In some embodiments, processor 610 includes a memory controller 614, which is operable to perform functions that enable the processor 610 to access and communicate with memory 630 that includes a volatile memory 632 and/or a non-volatile memory 634. In some embodiments, processor 610 is coupled with memory 630 and chipset 620. Processor 610 may also be coupled to a wireless antenna 678 to communicate with any device configured to transmit and/or receive wireless signals. In one embodiment, the wireless antenna interface 678 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 632 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 634 includes, but is not limited to, flash memory, phase change memory (PCM), read-only memory (ROM), electrically erasable programmable read-only memory (EEPROM), or any other type of non-volatile memory device.

Memory 630 stores information and instructions to be executed by processor 610. In one embodiment, memory 630 may also store temporary variables or other intermediate information while processor 610 is executing instructions. In the illustrated embodiment, chipset 620 connects with processor 610 via Point-to-Point (PtP or P-P) interfaces 617 and 622. Chipset 620 enables processor 610 to connect to other elements in system 600. In some embodiments of the invention, interfaces 617 and 622 operate in accordance with a PtP communication protocol such as the Intel^{®} QuickPath Interconnect (QPI) or the like. In other embodiments, a different interconnect may be used.

In some embodiments, chipset 620 is operable to communicate with processor 610, 605N, display device 640, and other devices 672, 676, 674, 660, 662, 664, 666, 677, etc. Chipset 620 may also be coupled to a wireless antenna 678 to communicate with any device configured to transmit and/or receive wireless signals.

Chipset 620 connects to display device 640 via interface 626. Display 640 may be, for example, a liquid crystal display (LCD), a plasma display, cathode ray tube (CRT) display, or any other form of visual display device. In some embodiments of the invention, processor 610 and chipset 620 are merged into a single SOC. In addition, chipset 620 connects to one or more buses 650 and 655 that interconnect various elements 674, 660, 662, 664, and 666. Buses 650 and 655 may be interconnected together via a bus bridge 672. In one embodiment, chipset 620 couples with a non-volatile memory 660, a mass storage device(s) 662, a keyboard/mouse 664, and a network interface 666 via interface 624 and/or 604, smart TV 676, consumer electronics 677, etc.

In one embodiment, mass storage device 662 includes, but is not limited to, a solid state drive, a hard disk drive, a universal serial bus flash memory drive, or any other form of computer data storage medium. In one embodiment, network interface 666 is implemented by any type of well known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in FIG. 6 are depicted as separate blocks within the system 600, the functions performed by some of these blocks may be integrated within a single semiconductor circuit or may be implemented using two or more separate integrated circuits. For example, although cache memory 616 is depicted as a separate block within processor 610, cache memory 616 (or selected aspects of 616) can be incorporated into processor core 612.

### Additional Notes

The following, non-limiting examples, detail certain aspects of the present subject matter to solve the challenges and provide the benefits discussed herein, among others.

Example 1 is a microelectronics package comprising: a substrate including a first subset of vias and a second subset of vias; a bridge located in between the first subset and the second subset of vias; and a material on the substrate, the material comprising a first portion located proximate the first subset of vias, and a second portion located proximate the second subset of vias, the material comprising titanium, a build-up material, a solder material, or a combination thereof, wherein the first and second portions define a partial boundary of a cavity formed within the substrate, wherein the bridge is located within the cavity and on the material.

In Example 2, the subject matter of Example 1 optionally includes wherein the material comprises a metallic substance.

In Example 3, the subject matter of any one or more of Examples 1-2 optionally include wherein the material comprises a dielectric substance.

In Example 4, the subject matter of any one or more of Examples 1-3 optionally include first and second dies connected to the substrate and in electrical communication the bridge.

In Example 5, the subject matter of Example 4 optionally includes a second material attached to the substrate; a third die; and a second bridge connected to the second material and in electrical communication with the third die and at least one of the first and second dies.

In Example 6, the subject matter of Example 5 optionally includes wherein the second material comprises a titanium plate, an Ajinomoto build-up film, a solder resist plate, or a combination thereof.

In Example 7, the subject matter of any one or more of Examples 4-6 optionally include a third die and a second bridge connected to the material, the second in electrical communication with the third die and at least one of the first and second dies.

Example 8 is a microelectronics package comprising: a substrate including a first subset of pillars and a second subset of pillars; a first die attached to the substrate and the first subset of pillars; a second die attached to the substrate and the second set of pillars; a material attached to the substrate, the material comprising a first portion located proximate the first subset of pillars, and a second portion located proximate the second subset of pillars, the material comprising titanium, a build-up material, a solder material, or a combination thereof; and a bridge attached to the material and electrically coupling the first die and the second die.

In Example 9, the subject matter of Example 8 optionally includes wherein the material comprises a metallic substance.

In Example 10, the subject matter of any one or more of Examples 8-9 optionally include wherein the material comprises a dielectric substance.

In Example 11, the subject matter of any one or more of Examples 8-10 optionally include a second material attached to the substrate; a third die; and a second bridge connected to the second material and in electrical communication with the third die and at least one of the first and second dies.

In Example 12, the subject matter of Example 11 optionally includes wherein the second material comprises a titanium plate, an Ajinomoto build-up film, a solder resist plate, or a combination thereof.

In Example 13, the subject matter of any one or more of Examples 8-12 optionally include a third die and a second bridge connected to the material, the second in electrical communication with the third die and at least one of the first and second dies.

Example 14 is a method of constructing a microelectronics package, the method comprising: attaching a material to a carrier; forming a first portion of a substrate on the carrier, the substrate covering the material; forming a cavity in the substrate, the cavity exposing a portion of a surface of the material; attaching a bridge to the surface of the material exposed during the forming of the cavity; applying pressure to the bridge to hold the bridge in a fixed position; and forming a second portion of the substrate while maintaining the pressure applied to the bridge.

In Example 15, the subject matter of Example 14 optionally includes wherein attaching the material to the carrier comprises attaching a titanium plate to the carrier.

In Example 16, the subject matter of any one or more of Examples 14-15 optionally include wherein attaching the material to the carrier comprises attaching a dielectric substance to the carrier.

In Example 17, the subject matter of any one or more of Examples 14-16 optionally include wherein attaching the material to the carrier comprises attaching an Ajinomoto build-up film, a solder resist plate, or a combination thereof to the carrier.

In Example 18, the subject matter of any one or more of Examples 14-17 optionally include wherein applying pressure to the bridge comprises increasing an air pressure within a chamber housing the microelectronics package during forming the second portion of the substrate.

In Example 19, the subject matter of any one or more of Examples 14-18 optionally include wherein applying pressure to the bridge comprises applying an increased air pressure to exposed surfaces of bridge during forming the second portion of the substrate.

In Example 20, the subject matter of any one or more of Examples 14-19 optionally include attaching first and second dies to the substrate and bridge.

In Example 21, the microelectronics packages, systems, apparatuses, or method of any one or any combination of Examples 1 - 20 can optionally be configured such that all elements or options recited are available to use or select from.

The above detailed description includes references to the accompanying drawings, which form a part of the detailed description. The drawings show, by way of illustration, specific embodiments in which the invention can be practiced. These embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A microelectronics package comprising:
a substrate including a first subset of vias and a second subset of vias;
a bridge located in between the first subset and the second subset of vias; and
a material on the substrate, the material comprising a first portion located proximate the first subset of vias, and a second portion located proximate the second subset of vias, the material comprising titanium, a build-up material, a solder material, or a combination thereof,
wherein the first and second portions define a partial boundary of a cavity formed within the substrate, wherein the bridge is located within the cavity and on the material.

2. The microelectronics package of claim 1, wherein the material comprises a metallic substance.

3. The microelectronics package of claim 1, wherein the material comprises a dielectric substance.

4. The microelectronics package of any one of or any combination of claims 1-3, further comprising first and second dies connected to the substrate and in electrical communication the bridge.

5. The microelectronics package of claim 4, further comprising:
a second material attached to the substrate;
a third die; and
a second bridge connected to the second material and in electrical communication with the third die and at least one of the first and second dies.

6. The microelectronics package of claim 5, wherein the second material comprises a titanium plate, an Ajinomoto build-up film, a solder resist plate, or a combination thereof.

7. The microelectronics package of claim 4, 5 or 6, further comprising a third die and a second bridge connected to the material, the second in electrical communication with the third die and at least one of the first and second dies.

8. A method of constructing a microelectronics package, the method comprising:
attaching a material to a carrier;
forming a first portion of a substrate on the carrier, the substrate covering the material;
forming a cavity in the substrate, the cavity exposing a portion of a surface of the material;
attaching a bridge to the surface of the material exposed during the forming of the cavity;
applying pressure to the bridge to hold the bridge in a fixed position; and
forming a second portion of the substrate while maintaining the pressure applied to the bridge.

9. The method of claim 8, wherein attaching the material to the carrier comprises attaching a titanium plate to the carrier.

10. The method of claim 8, wherein attaching the material to the carrier comprises attaching a dielectric substance to the carrier.

11. The method of claim 8, wherein attaching the material to the carrier comprises attaching an Ajinomoto build-up film, a solder resist plate, or a combination thereof to the carrier.

12. The method of any one of or any combination of claims 8-11, wherein applying pressure to the bridge comprises increasing an air pressure within a chamber housing the microelectronics package during forming the second portion of the substrate.

13. The method of any one of or any combination of claims 8-12, wherein applying pressure to the bridge comprises applying an increased air pressure to exposed surfaces of bridge during forming the second portion of the substrate.

14. The method of any one of or any combination of claims 8-13, further comprising attaching first and second dies to the substrate and bridge.

15. A microelectronics package comprising:
a substrate including a first subset of pillars and a second subset of pillars;
a first die attached to the substrate and the first subset of pillars;
a second die attached to the substrate and the second set of pillars;
a material attached to the substrate, the material comprising a first portion located proximate the first subset of pillars, and a second portion located proximate the second subset of pillars, the material comprising titanium, a build-up material, a solder material, or a combination thereof; and
a bridge attached to the material and electrically coupling the first die and the second die.
